Europäisches Patentamt

European Patent Office

Office européen des brevets

(11) Publication number: **0 392 637**
**A2**

# EUROPEAN PATENT APPLICATION

(21) Application number: **90200906.7**

(51) Int. Cl.5: **H05K 13/00**

(22) Date of filing: **11.04.90**

(30) Priority: **14.04.89 US 337856**

(43) Date of publication of application:
**17.10.90 Bulletin 90/42**

(84) Designated Contracting States:
**DE FR GB NL**

(71) Applicant: **UNIVERSAL INSTRUMENTS
CORPORATION (Delaware Corp.)**
**P.O. Box 825**
**Binghamton New York 13902-0825(US)**

(72) Inventor: **Soth, Henry J.**
**P.O. Box 111D**
**Brackney, Pennsylvania(US)**

(74) Representative: **Hoijtink, Reinoud et al**
**OCTROOIBUREAU ARNOLD & SIEDSMA**
**Sweelinckplein 1**
**NL-2517 GK Den Haag(NL)**

(54) Adjustable shutter for containment of small electronics components in tape feeders.

(57) A feeder mechanism for a pick-and-place machine with an adjustable shutter mechanism is disclosed. The components are contained within pockets formed in a reeled tape. The shutter mechanism includes a pair of spring blades that cover the pocket, but are spread apart by the vacuum tip when the spindle is lowered. In this way, the shutter can maintain the component in the proper position for pick-up while allowing the vacuum spindle to access the component, which, in turn, maintains proper attitude of component while the blades are retracted.

FIG. 1

# ADJUSTABLE SHUTTER FOR CONTAINMENT OF SMALL ELECTRONICS COMPONENTS IN TAPE FEEDERS

The present invention is directed to a tape feeder for feeding small electronics components to a pick and place machine for placement on a circuit board and, in particular, to such a tape feeder having an adjustable shutter for containing the component prior to being picked-up.

## BACKGROUND OF THE INVENTION

In conventional tape feeders for pick and place machines, the components are typically stored in pockets in reeled tape. A cover or shutter seals each components in its pocket. In these typical tape feeders, the shutter that contains the part during transport of the tape is opened to expose the parts for pick-up by a vacuum tip shortly after indexing. In high speed applications (on the order of 50 milliseconds for 4 millimeters of index length), the part becomes unstable and oftentimes changes attitude or completely flips over in its surrounding pocket after the shutter is opened. This, of course, makes it difficult or impossible to retrieve the component.

To overcome these disadvantages, a flat shutter was developed, as seen in U.S. Patent No. 4,740,136. An access slot or notch with a width narrower than that of the chip and wider than that of the vacuum tip is formed in the flat shutter. A vacuum tip fits through the access slot to hold the component at the proper attitude for pick-up. Once the chip is captivated, the shutter is withdrawn and the chip is lifted from the pocket. However, this device has the disadvantage that it requires the tip to have a smaller cross-sectional area than the surface area of the upper face of the chip. Therefore, extremely small chips cannot be handled with this device.

Another shutter mechanism is shown in Application Serial No. 07/27,991, commonly assigned herewith, the contents of which are incorporated herein by reference. The device disclosed in this application uses a finger projecting from the pick-and-place head. The finger engages a shutter actuating lever, which laterally displaces the shutter to provide access to the component.

## SUMMARY OF THE INVENTION

The present invention overcomes the above disadvantages by providing a shutter that permits the spindle to hold the components in position for pick-up before the shutter is withdrawn. The shutter includes a pair of spring blades that are opened by the spindle tip to create an access slot to the pocket that holds the component. Once the component is firmly held in position by the spindle. The shutter is withdrawn or displaced in order to remove the component.

This arrangement is advantageous in that it allows the tip of the pick-up spindle to be slightly larger than the component, while preventing the component from changing attitude. Of course, the present invention may be used to pick-up components that are the same size or larger than the spindle tip. Another advantage of this arrangement is that the shutter acts as a guide for the spindle to prevent any inadvertent movement of the spindle. A further advantage of this arrangement is that the vacuum may be switched on prior to contacting the tip to the component, since the shutter maintains the component in a balanced position and acts as an escapement mechanism that holds the component stable.

## BRIEF DESCRIPTION OF THE DRAWINGS

Figure 1 shows a perspective view of the tape feeder device and shutter in accordance with a first preferred embodiment of the present invention;

Figure 2 shows a perspective view of the shutter portion of the device shown in Figure 1;

Figure 3 shows a perspective view of the shutter in accordance with a second preferred embodiment of the present invention;

Figure 4 shows a perspective view of the shutter shown in Figure 3, with the shutter withdrawn to permit installation of a fresh reel of components.

## DETAILED DESCRIPTION OF THE PREFERRED EMBODIMENTS

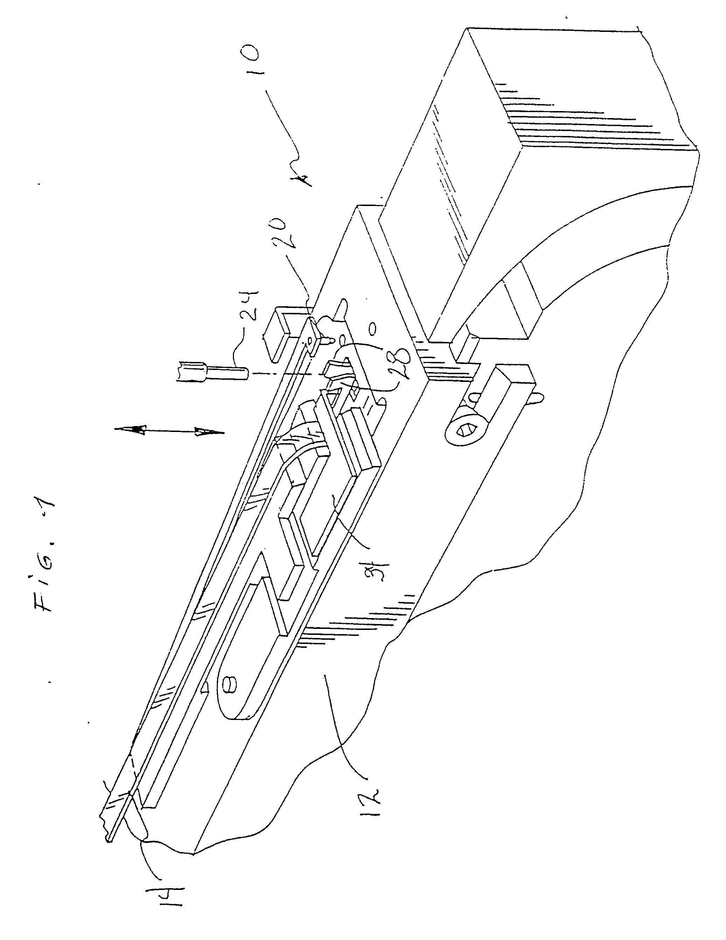

A first preferred embodiment of the feeder device with shutter mechanism in accordance with the present invention is shown in Figure 1 and generally designated 10. Throughout the figures, like numerals will be used to designate like elements.

Feeder device 10 includes primary frame 12 for supporting reeled tape 14 thereon. The tape includes pockets 16. Each pocket 16 contains an individual small electronic component (not shown) on the order of 20 x 30 mils. up to 1/8 x 1/8 inches.

The tape further includes indexing holes 18 which cooperate with indexing pin 20 and an indexing mechanism (not shown) to present each of the pockets consecutively to a pick-up mechanism for removal from the pocket and placement on a circuit board.

In the preferred embodiments, a pick-and-place head is used to pick-up the components for placement on the circuit board. The pick-up head includes spindle 22 and vacuum tip 24 connected thereto.

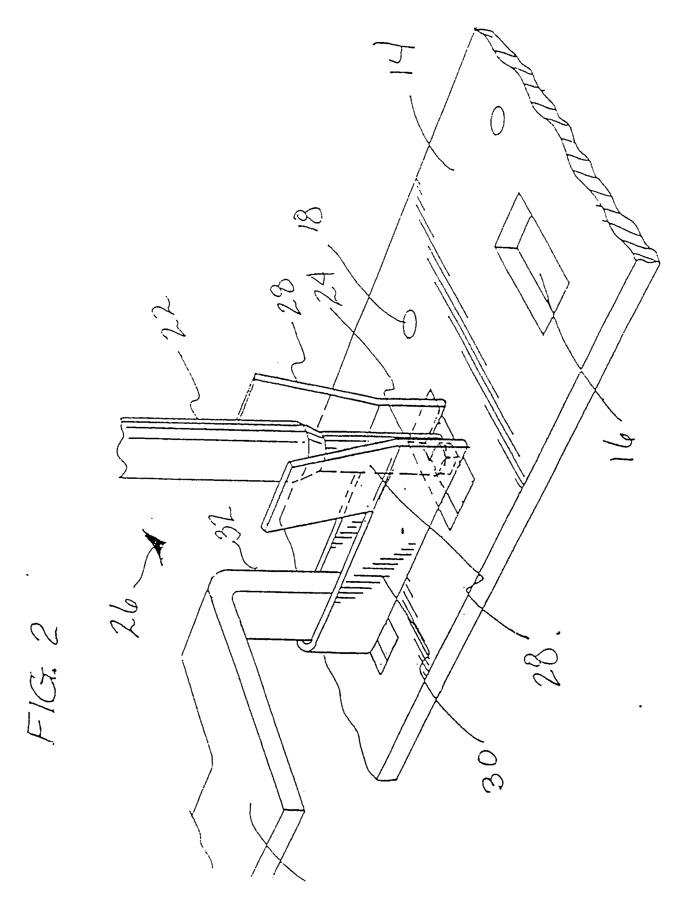

As can be seen more clearly in Figure 2, shutter mechanism 26 includes spring blades 28 formed of a spring material, such as stainless steel. The depth of the spring blades should be sufficient that the blades can be angled to form a tapered arrangement (narrower at the bottom), thus allowing the spindle tip to more easily spread the blades to form an access slot over the component, as will be explained in more detail below.

In this first preferred embodiment, the spring blades are preferably connected via U-shaped connection member 30 which is fitted around downwardly extending portion 32 of pivot bracket 34. The spring blades thus extend upwardly from the ends of the connection member. The pivot bracket can be manually pivoted upwardly to move the shutter mechanism out of the way for servicing of the tape or the like.

In operation, the component supply tape is indexed to present each pocket consecutively at the pick-up station. The top cover (not shown) is peeled back so that each pocket is opened in turn. As the cover is removed, the shutter mechanism 26 is positioned over the pocket. The vacuum spindle is then lowered so that the tip spreads the blades open. Because the blades grip the spindle, they compensate for any play in the movement of the spindle. The vacuum is then switched on, while the blades maintain the component at its proper attitude. Alternatively, the vacuum may be switched on prior to lowering the tip. The blades are moved axially to disengage from the spindle. The vacuum tip is then raised to withdraw the component from the tape. In this way, the device of the present invention permits the spindle to easily pick-up components that are smaller in cross-sectional area than the vacuum tip itself, as clearly shown in Figure 2.

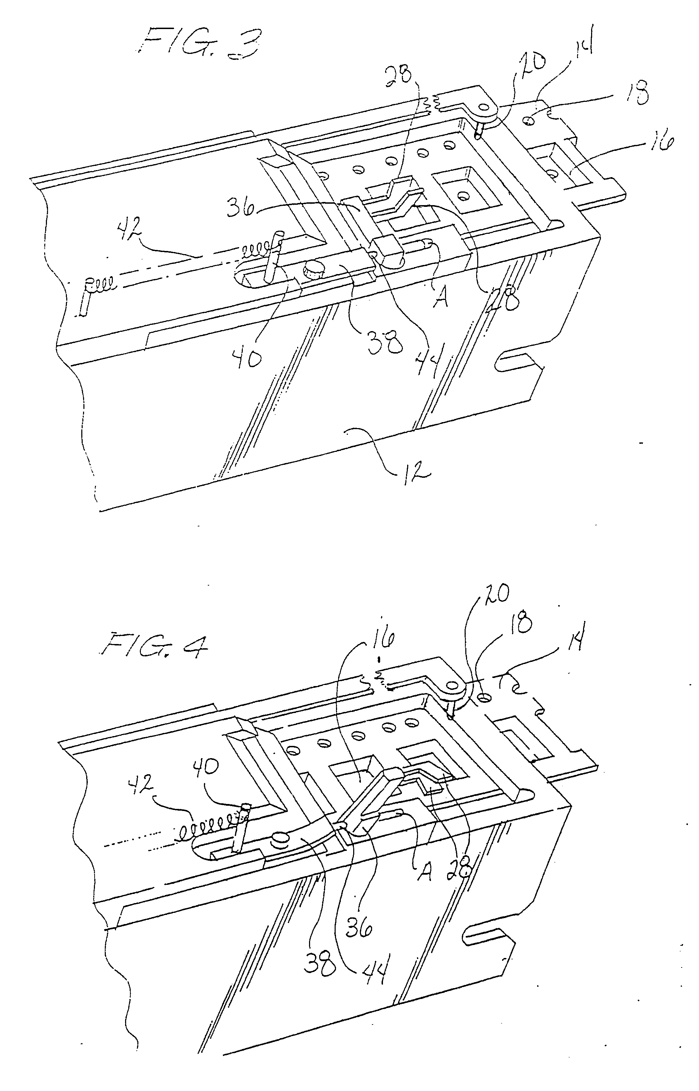

A second preferred embodiment of the feeder device and shutter mechanism in accordance with the present invention is shown in Figure 3. This embodiment of the invention uses spring blades 28, as in the first preferred embodiment, connected to one end of flip mechanism 36. Flip mechanism 36 is preferably bar-shaped, although other suitable shapes may be used. The other end of the flip mechanism is coupled to flat spring 38. The flat spring is connected at its other end via pin 40 to tension spring 42.

Flip mechanism 36 is operably coupled to pin 44 which extends from point A to underneath flat spring 38. The pin has flattened sides so that, when the flip device is manually pivoted upwardly to permit changing or servicing of the component supply tape, the flattened sides co-act with the underside of the flat spring to maintain the flip device in its upright position.

The entire assembly of flat spring 38, flip mechanism 36 and blades 28 moves. In this way, the shutter can be moved axially out of the way to permit pick-up of components having an upper surface area greater than the cross-sectional area of the vacuum tip.

The foregoing is for illustrative purposes only. Modifications can be made, particularly with regard to size, shape and arrangement of parts, within the scope of the invention as defined by the appended claims. For example, it is envisioned that the blades and the connector member of the shutter mechanism can be coplanar and both angled so that no upstanding blade portions are necessary.

## Claims

1. A shutter device for use in conjunction with a pick and place twice for high-speed handling of small electronic components contained within pockets along a component supply tape, said shutter device comprising:

a pair of upwardly extending spring blades, said spring blades being openable by a vacuum tip so as to form an access slot through which the vacuum tip can access the component for pick-up while said spring blades maintain the component at the proper attitude within the pocket until the shutter device is removed;

a connecting means for connecting said spring blades; and

a withdrawing means operably coupled to said connecting means for withdrawing said shutter device so that said spring blades are disengaged from the spindle, thus permitting the spindle to withdraw the component from the pocket.

2. A device as in claim 1, wherein said spring blades are disposed at an angle to facilitate ease in inserting the vacuum tip therebetween.

3. A device as in claim 1, wherein said spring blades are formed of stainless steel.

4. A device as in claim 1, wherein said withdrawal means includes a pivot bracket having a downwardly extending portion coupled to said connector means and said pivot bracket can be manually pivoted upwardly to maintain said spring blades in an upright position for servicing or replacement of the component supply tape.

5. A device as in claim 4, wherein said connector means is substantially U-shaped and one of said spring blades extends upwardly from each end of said connector means.

6. A device as in claim 1, wherein the vacuum tip has a cross-sectional area greater than the surface area of the upper face of the component.

7. A device as in claim 1, wherein said connector means is a flip bar.

8. A device as in claim 7, wherein said withdrawal means is a flat spring and said flip bar is operably connected to said flat spring via a flattened pin, said pin co-acting with a bottom surface of said flat spring when said flip device is pivoted upwardly to maintain said flip device and said spring blades in an upright position for servicing or replacement of the component supply tape.

9. A feeder device for high-speed feeding of electronic components contained within pockets of a reeled tape which is indexed to present each pocket and the component therein sequentially to be picked-up, said device comprising:
[an indexing means for indexing said tape to present a pocket and the component contained therein to a pick-up station;]
a shutter means for covering said pocket at said pick-up station, said shutter means including a pair of upwardly extending spring blades; and
a movable pick-up head means for opening said shutter means sufficiently to access the component prior to removal from the pocket, said pick-up head means having a cross-sectional tip surface area greater than or equal to the surface area of the upper face of the component.

FIG. 1

FIG. 2

EP 0 392 637 A2

FIG. 3

FIG. 4